(19) Europäisches Patentamt / European Patent Office / Office européen des brevets

(11) **EP 4 647 787 A1**

(12) **DEMANDE DE BREVET EUROPEEN**

(43) Date de publication:
**12.11.2025 Bulletin 2025/46**

(21) Numéro de dépôt: **25174252.4**

(22) Date de dépôt: **05.05.2025**

(51) Classification Internationale des Brevets (IPC):
**G01R 31/367** (2019.01)   **G01R 31/392** (2019.01)
**H02J 7/00** (2006.01)   H01M 10/48 (2006.01)

(52) Classification Coopérative des Brevets (CPC):
**G01R 31/367; G01R 31/392; H01M 10/425;
H01M 10/44; H01M 10/48; H02J 7/005;**
G01R 31/374; G01R 31/382; G01R 31/389;
H01M 2010/4271; H01M 2010/4278

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **07.05.2024 FR 2404815**

(71) Demandeurs:
• **Safran Electrical & Power
31702 Blagnac (FR)**

• **Université de Technologie de Compiègne
60200 Compiègne (FR)**

(72) Inventeurs:
• **VENDRAME, Fernanda
77550 MOISSY-CRAMAYEL (FR)**
• **BAKARAKI, Ghada
77550 MOISSY-CRAMAYEL (FR)**

(74) Mandataire: **Cabinet Camus Lebkiri
25 rue de Maubeuge
75009 Paris (FR)**

(54) **PROCÉDÉ DE SURVEILLANCE D'UN ÉTAT DE SANTÉ D'UNE BATTERIE**

(57)    Procédé (100) de surveillance d'un état de santé SOH d'une batterie, comprenant des étapes de :
- Charge (110) initiale de la batterie jusqu'à atteindre une première tension $U_{stop}$ prédéterminée, la charge initiale de la batterie étant effectuée en appliquant un courant constant,
- Mise au repos (120) de la batterie pendant une durée adaptée pour qu'à une fin de la mise au repos :
- une tension de la batterie soit égale, ou suffisamment proche, à une tension en circuit ouvert OCV de la batterie, et
- une température de la batterie soit stable,

- obtention (130) d'un indicateur de la batterie parmi :
- la tension en circuit ouvert OCV de la batterie,
- une résistance en courant continu DCR de la batterie,

- obtention (140) d'un modèle de la batterie prenant en entrée l'indicateur de la batterie et fournissant en sortie l'état de santé SOH de la batterie, et
- détermination (150) de l'état de santé SOH de la batterie en fournissant au modèle obtenu (140) l'indicateur obtenu (130).

EP 4 647 787 A1

**Description**

## DOMAINE TECHNIQUE DE L'INVENTION

Le domaine technique de l'invention est celui de la surveillance et de la gestion des batteries électriques, en particulier des batteries embarquées dans un véhicule, notamment dans un aéronef.

La présente invention concerne notamment un procédé de surveillance de l'état de santé d'une batterie.

## ARRIERE-PLAN TECHNOLOGIQUE DE L'INVENTION

Le changement climatique est une préoccupation majeure pour de nombreux organes législatifs et de régulation à travers le monde. En effet, diverses restrictions sur les émissions de carbone ont été, sont ou seront adoptées par divers Etats. En particulier, une norme ambitieuse s'applique à la fois aux nouveaux types d'avions mais aussi ceux actuellement en circulation nécessitant de devoir mettre en œuvre des solutions technologiques afin de les rendre conformes aux réglementations en vigueur. L'aviation civile se mobilise depuis maintenant plusieurs années pour apporter une contribution à la lutte contre le changement climatique.

Les efforts de recherche technologique ont déjà permis d'améliorer de manière très significative les performances environnementales des avions. La Déposante prend en considération les facteurs impactant toutes les phases de conception et de développement, pour obtenir des composants et des produits aéronautiques moins énergivores, plus respectueux de l'environnement et dont l'intégration et l'utilisation dans l'aviation civile ont des impacts environnementaux modérés dans un but d'amélioration de l'efficacité énergétique des avions. La Déposante travaille en permanence à la réduction de son impact climatique par l'emploi de méthodes et l'exploitation de procédés de développement et de fabrication vertueux et minimisant les émissions de gaz à effet de serre au minimum possible pour réduire de l'empreinte environnementale de son activité.

Ces travaux de recherche et de développement soutenus portent à la fois sur les nouvelles générations de moteurs d'avion, l'allègement des appareils, notamment par les matériaux employés et les équipements embarqués allégés, le développement de l'emploi des technologies électriques pour assurer la propulsion, et enfin les biocarburants aéronautiques.

Dans ce cadre, l'utilisation et la gestion des batteries électriques au sein des aéronefs doit être optimisée. L'état de santé d'une batterie, aussi couramment appelé SOH pour « State of Health » en anglais, peut être défini en fonction de la perte de capacité ou du gain de résistance d'une batterie tout au long de sa vie. Dans la présente demande, l'état de santé SOH est défini par :

$$SOH = \frac{c_{actuelle}}{c_{initiale}} \times 100\ \%$$

Avec :

- $c_{actuelle,}$ la capacité maximale actuelle de la batterie

- $c_{initiale,}$ la capacité maximale initiale de la batterie

En fonction de l'état de santé d'une batterie, l'utilisation de la batterie peut être modifiée. Par exemple, dans le secteur des transports, les batteries sont habituellement utilisées jusqu'à un état de santé seuil compris entre 70% et 80%. Cette première utilisation correspond à ce que l'on appelle la « première vie » d'une batterie. En-dessous de cet état de santé seuil, la perte de capacité tend à s'accélérer, mais la batterie peut continuer à être utilisée dans des applications dites de « seconde vie », telles que les réseaux d'énergie de type « smart grid ».

Pour des applications embarquées, et notamment dans un aéronef, il est donc primordial de mesurer ou d'estimer l'état de santé d'une batterie. Des méthodes connues permettent de surveiller l'état de santé de la batterie sans nécessiter de démonter la batterie de l'appareil sur laquelle elle est embarquée.

Une première méthode connue, divulguée dans Shen, P., Ouyang, M., Lu, L., Li, J., & Feng, X. (2018). The co-estimation of State of Charge, State of Health, and State of Function for lithium-ion batteries in electric vehicles. IEEE Transactions on Vehicular Technology, 67(1), 92-103, propose d'estimer l'état de santé d'une batterie en se basant sur une méthode des moindres carrés récursifs avec facteur d'oubli. Cette méthode est très complète car elle permet en outre d'estimer l'état de charge et l'état de fonctionnement de la batterie. Toutefois, cette méthode est complexe à implémenter.

Une deuxième méthode connue, dans Zhou, Y., Huang, M., & Pecht, M. (2018, August 27). An Online State of Health Estimation Method for Lithium-ion Batteries Based on Integrated Voltage. 2018 IEEE International Conference on Prognostics and Health Management, ICPHM 2018, divulgue qu'il existe une corrélation linéaire entre l'état de santé d'une batterie et l'intégrale de la tension pendant une partie de la charge d'une batterie. Cependant, cette méthode nécessite de prendre en compte une plage d'états de charge de la batterie qui soit très large (par exemple entre 10% de charge et 90% de charge), ce qui n'est pas effectué systématiquement en fonction de l'application. De plus, la plage de l'état de charge de la batterie à couvrir pour mettre en œuvre cette méthode n'est pas compatible avec certaines utilisations.

Il existe donc un besoin de fournir une méthode de détermination d'un état de santé d'une batterie permettant de résoudre au moins partiellement les inconvénients des méthodes de l'art antérieur.

## RESUME DE L'INVENTION

L'invention offre une solution aux problèmes évoqués précédemment, en permettant de déterminer un état de santé SOH d'une batterie avec une méthode simple à implémenter et qui soit compatible avec une utilisation courante de la batterie, par exemple embarquée dans un aéronef.

Un aspect de l'invention concerne un procédé de surveillance d'un état de santé SOH d'une batterie, comprenant des étapes de :

- charge initiale de la batterie jusqu'à atteindre une première tension $U_{stop}$ prédéterminée, la charge initiale de la batterie étant effectuée en appliquant un courant constant,

- mise au repos de la batterie pendant une durée adaptée pour qu'à une fin de la mise au repos :

  - une tension de la batterie soit égale, ou suffisamment proche, à une tension en circuit ouvert OCV de la batterie, et

  - une température de la batterie soit stable,

- obtention d'un indicateur de la batterie parmi :

  - la tension en circuit ouvert OCV de la batterie,
  - une résistance en courant continu DCR de la batterie,

- obtention d'un modèle de la batterie prenant en entrée l'indicateur de la batterie et fournissant en sortie l'état de santé SOH de la batterie, et

- détermination de l'état de santé SOH de la batterie en fournissant au modèle obtenu l'indicateur obtenu.

Grâce à l'invention, la surveillance de l'état de santé de la batterie peut être effectuée facilement et directement dans un système embarqué. En effet, la mise en œuvre du procédé selon l'invention est économe en ressources de calcul et ne nécessite pas d'effectuer une décharge complète et/ou une charge complète de la batterie, car cela n'est pas réaliste d'un point de vue opérationnel. Le procédé de l'invention permet en effet d'obtenir une estimation de l'état de santé de la cellule électrique en balayant une plage assez réduite d'états de charge de la cellule.

Le procédé selon l'invention se base, dans un premier mode d'implémentation, sur une relation claire entre l'état de santé de la batterie et la tension mesurée entre deux étapes d'un protocole spécifique de charge. L'état de santé de la batterie a également une relation claire, utilisée dans un second mode d'implémentation, avec la résistance interne de la batterie calculée au début de la deuxième étape de la charge du protocole spécifique.

Outre les caractéristiques qui viennent d'être évoquées dans le paragraphe précédent, le procédé de surveillance selon un aspect de l'invention peut présenter une ou plusieurs caractéristiques complémentaires parmi les suivantes, considérées individuellement ou selon toutes les combinaisons techniquement possibles :

- le procédé comprend en outre une charge complémentaire de la batterie :

  - pendant une durée prédéterminée, et/ou

  - jusqu'à atteindre une seconde tension $U_{max}$ prédéterminée, et/ou

  - un état de charge prédéterminé,

- le procédé comprend en outre une modification des conditions d'utilisation de la batterie en fonction de l'état de santé SOH déterminé, la modification des conditions d'utilisation de la batterie comprenant :

  - lorsque l'état de santé SOH déterminé est inférieur à une valeur seuil d'état de santé prédéterminé, remplacer la batterie par une nouvelle batterie, et/ou

  - charger la batterie, lors de la charge complémentaire à une intensité de courant inférieure ou égale à une intensité de courant maximale, l'intensité de courant maximale étant déterminée à partir de l'état de santé SOH déterminé,

- la durée de la mise au repos de la batterie est égale ou supérieure à une heure,

- l'indicateur de la batterie est la tension en circuit ouvert OCV de la batterie,

- l'indicateur de la batterie est la résistance en courant continu DCR de la batterie, et l'obtention de la résistance en courant continu DCR de la batterie est effectuée au début de la charge additionnelle de la batterie.

Un deuxième aspect de l'invention concerne un système de gestion d'une batterie électrique comprenant des moyens de mise en œuvre du procédé selon l'invention.

Un troisième aspect de l'invention concerne un aéronef comprenant une batterie électrique et un système de gestion de la batterie selon l'invention.

Un quatrième aspect de l'invention concerne un programme d'ordinateur comprenant des instructions qui, lorsque le programme est exécuté par un ordinateur, conduisent celui-ci à mettre en œuvre un procédé selon l'invention.

Un cinquième aspect de l'invention concerne un support de données lisible par ordinateur, sur lequel est enregistré le programme d'ordinateur selon l'invention.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre un schéma synoptique d'un exemple de procédé de surveillance d'un état de santé SOH d'une batterie selon l'invention.

- La figure 2 est un graphique illustrant un exemple d'évolution d'un état de santé SOH d'une batterie en fonction d'une tension en circuit ouvert OCV de la batterie.

- La figure 3 est un graphique montrant un exemple de relation entre un état de santé SOH de la batterie et une résistance en courant continu DCR.

- La figure 4 est un graphique illustrant un exemple de profil du courant et de profil de la tension de la batterie lors d'un protocole de charge intégrant un exemple de procédé selon l'invention.

## DESCRIPTION DETAILLEE

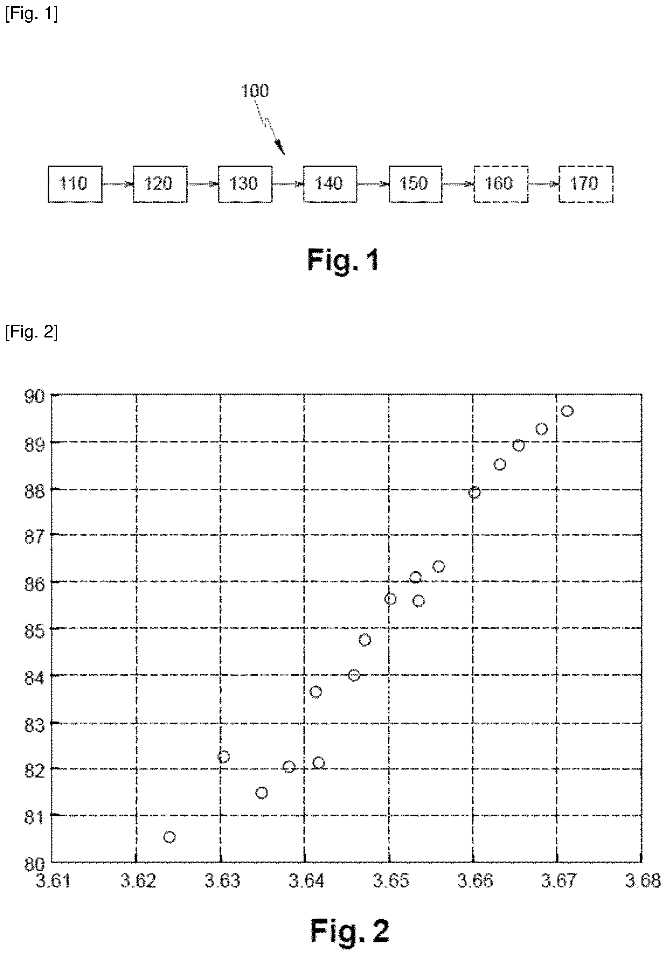

La figure 1 est un schéma synoptique illustrant les étapes d'un exemple du procédé 100 de surveillance d'un état de santé SOH d'une batterie électrique. Les étapes facultatives de l'exemple du procédé 100 sont indiquées par un rectangle en traits pointillés.

Le procédé 100 peut être mis en œuvre par un ordinateur, par un processeur ou par un microprocesseur. Par exemple, le procédé 100 peut être mis en œuvre par un microprocesseur compris dans un système de gestion d'une ou de plusieurs batteries électriques d'un système embarqué tel qu'un aéronef. Le système de gestion a de préférence la structure d'un calculateur (en l'occurrence un calculateur de bord), et/ou d'un ordinateur. Il comprend un circuit électronique (en une ou plusieurs parties) équipé au moins d'une mémoire de type non-volatile, et d'un processeur permettant d'exécuter des opérations logiques. Il peut comprendre aussi une ou plusieurs autres mémoires, de type mémoire vive (RAM) ou d'un autre type, et un ou plusieurs autres processeurs. Le système de gestion peut aussi comprendre des moyens de mesure :

- du courant appliqué à la ou les batteries électriques,

- de la température de la ou les batteries électriques, et

- de la tension de la ou les batteries électriques.

Par « mis en œuvre par ordinateur », on entend que les étapes, ou pratiquement toutes les étapes, sont exécutées par au moins un ordinateur ou processeur ou tout autre système similaire. Ainsi, des étapes sont réalisées par le calculateur, éventuellement de manière entièrement automatique, ou semi-automatique. Dans des exemples, le déclenchement d'au moins certaines des étapes du procédé peut être effectué par interaction utilisateur-ordinateur. Le niveau d'interaction utilisateur-ordinateur requis peut dépendre du niveau d'automatisme prévu et mis en balance avec la nécessité de mettre en œuvre les souhaits de l'utilisateur. Dans des exemples, ce niveau peut être défini par l'utilisateur et/ou prédéfini.

Un exemple typique de mise en œuvre par ordinateur d'un procédé consiste à exécuter le procédé avec un système adapté à cet effet. Le système peut comprendre un processeur couplé à une mémoire et une interface utilisateur graphique (GUI), un programme informatique comprenant des instructions pour mettre en œuvre le procédé étant enregistré dans la mémoire. La mémoire peut également stocker une base de données. La mémoire est tout matériel adapté pour un tel stockage, comprenant éventuellement plusieurs parties physiques distinctes.

Une première étape 110 du procédé 100 comprend la charge initiale de la batterie. Le terme « initiale » signifie, dans la présente demande, simplement que cette charge est la première charge du procédé 100. Le procédé 100 peut donc comprendre au moins une autre charge, appelée charge complémentaire ou deuxième charge. Cette charge initiale 110 est effectuée en appliquant un courant constant. La charge initiale s'arrête lorsque la tension de la batterie est égale, ou devient supérieure, à une première tension $U_{stop}$ prédéterminée.

Dans un exemple, la première tension $U_{stop}$ prédéterminée est comprise entre 3,5 et 4,1 volts, et préférentiellement entre 3,75 et 3,85 volts.

Une deuxième étape 120 du procédé 100 comprend la mise au repos de la batterie. Cette mise au repos doit être suffisamment longue afin que deux conditions soient vérifiées durant ou à la fin de cette mise au repos. La première condition est que la tension de la batterie soit égale, ou suffisamment proche, à la tension en circuit ouvert OCV de la batterie. Une tension de la batterie suffisamment proche de la tension en circuit ouvert OCV de la batterie est une tension égale à la tension en circuit ouvert OCV de la batterie avec une différence inférieure à XX volts. La seconde condition est que la température de la batterie soit stable, i.e. c'est-à-dire qu'elle ne varie plus dans le temps ou au moins que la variation de la température est inférieure de 0,5°C par heure.

Dans un exemple, compatible avec l'exemple précédent, la durée de la mise au repos 120 de la batterie est égale ou supérieure à une heure.

Une troisième étape 130 du procédé 100 comprend une obtention d'un indicateur de la batterie. L'indicateur de la batterie peut être :

- la tension en circuit ouvert OCV, pour « Open Circuit Voltage » en anglais, de la batterie, exprimée en volts, ou

- la résistance en courant continu DCR, pour « Direct Current Resistance » en anglais, de la batterie, exprimée en milliOhms (mΩ).

Le terme « obtention » signifie, dans la présente demande, recevoir et/ou mesurer et/ou calculer.

Pour rappel, la résistance en courant continu DCR est la résistance statique inhérente au conducteur, c'est-à-dire la résistance de la batterie en appliquant une certaine quantité de courant continu à la batterie. La résistance en courant continu DCR est calculée selon la loi d'Ohm. La résistance en courant continu DCR est la résistance calculé après un intervalle $\Delta t$ pré-défini. Par exemple, on peut parler d'une DCR 10s. pour une résistance en courant continu DCR calculée 10 secondes après avoir appliqué le courant.

Une quatrième étape 140 du procédé 100 comprend l'obtention d'un modèle de la batterie prenant en entrée l'indicateur de la batterie et fournissant en sortie l'état de santé SOH de la batterie. Dans un exemple, compatible avec les exemples précédents, le modèle peut comprendre une fonction qui définit l'état de santé SOH de la batterie en fonction de l'indicateur de la batterie. Par exemple, une fonction f permettant d'obtenir une équation de la forme suivante :

$$SOH = f(indicateur, T, I)$$

Avec :

- *indicateur,* l'indicateur de la batterie

- *T*, la température de la batterie, en °C, et

- *I*, l'intensité du courant électrique appliqué à la batterie, en ampères.

Dans cet exemple, l'équation *SOH = f(indicateur, T,I)* peut donc être ajustée aux données expérimentales, i.e. à la température T de la batterie et à l'intensité I du courant électrique appliqué à la batterie. Il est par exemple possible d'effectuer les mesures additionnelles de la température de la batterie et du courant électrique appliqué à la batterie durant l'étape 130. Avec ces mesures additionnelles, il est par exemple possible de recalibrer le modèle en fonction de la température à laquelle la charge est réalisée et en fonction du courant appliqué à la batterie durant la charge.

Dans un exemple, afin d'obtenir le modèle de la batterie prenant en entrée l'indicateur de la batterie et fournissant en sortie l'état de santé SOH de la batterie, il est possible de vieillir un ensemble de batteries de calibration et d'effectuer un ensemble de mesures lors du vieillissement de cet ensemble de batteries de calibration afin d'établir des équations *SOH = f(0CV)* et/ou *SOH = f(DCR)*. Les batteries de calibration sont similaires à la batterie pour laquelle le procédé 100 est mis en oeuvre. Le terme « similaire » signifie que les batteries de calibration ont des caractéristiques de tension de circuit ouvert, impédance interne, capacité et chimiques identiques à la batterie dont l'état de santé est surveillé avec le procédé 100. L'ensemble de batteries de calibration peut comprendre entre 10 et 100 batteries de calibration. Le vieillissement de chaque batterie de calibration est effectué sous différentes conditions de vieillissements. Par exemple, les batteries de calibration sont vieillies en étant sollicitées électriquement. Ce vieillissement est appelé le vieillissement en cyclage. Pour ce type de vieillissement, les conditions de vieillissements peuvent varier en fonction de la température ambiante, du courant de charge et/ou de décharge, de l'état de charge moyen pendant les cycles et de la profondeur de la décharge sur chaque cycle. Durant le vieillissement des batteries de calibration, des essais intermédiaires peuvent être effectués. Ces essais intermédiaires peuvent comprendre :

- la mesure de la capacité lors d'une décharge continue

- l'application d'un protocole de charge en deux étapes comprenant par exemple les étapes 110, 120,130 et 160.

Ces essais permettent donc de générer le modèle de la batterie prenant en entrée l'indicateur de la batterie et fournissant en sortie l'état de santé SOH de la batterie en établissant les équations *SOH = f(0CV)* et/ou *SOH = f(DCR)*. Lorsque le modèle de la batterie a été obtenu grâce aux essais, il peut évidemment être stocké et réutilisé de nombreuses fois pour surveiller l'état de santé SOH d'une batterie similaire aux batteries de calibration. Dit autrement, l'étape 140 peut consister à générer le modèle de la batterie, par exemple lorsqu'aucun modèle de batterie n'a été précédemment généré, ou simplement à recevoir ce modèle de batterie lorsqu'il a été précédemment généré.

Dans un premier mode d'implémentation, l'indicateur utilisé est la tension en circuit ouvert OCV. Dans ce premier mode d'implémentation, le modèle prend en entrée la tension en circuit ouvert OCV obtenue à l'étape 130 et fournit en sortie l'état de santé SOH de la batterie.

Dans un exemple de ce premier mode d'implémentation, le modèle peut comprendre l'équation linéaire suivante :

$$SOH(OCV) = m_1 \cdot OCV + m_2$$

Avec :

-    *OCV,* la tension en circuit ouvert OCV obtenue à l'étape 130

-    $m_1$, $m_2$, les coefficients à déterminer.

Ces coefficients $m_1$, $m_2$ peuvent être déterminés lorsque le modèle de la batterie est généré, par exemple à l'aide de l'exemple décrit précédemment, à l'aide d'un algorithme d'optimisation tel que la méthode des moindres carrés afin d'ajuster l'équation aux données expérimentales obtenues.

La figure 2 est un graphique illustrant un exemple d'évolution de l'état de santé SOH d'une batterie, représenté sur l'axe vertical et exprimé en pourcentages de la capacité $C_{ininale}$ maximale initiale de la batterie, en fonction de la tension en circuit ouvert OCV obtenue à l'étape 130. Ainsi il est possible d'observer sur la figure 2 que la relation entre ces deux variables est quasi-linéaire.

Dans un second mode d'implémentation, l'indicateur utilisé est la résistance en courant continu DCR. Dans ce second mode d'implémentation, le modèle prend en entrée la résistance en courant continu DCR calculée à l'étape 130 et fournit en sortie l'état de santé SOH de la batterie. Dans ce second mode d'implémentation, l'obtention130 de la résistance en courant continu DCR est de préférence mise en œuvre au début d'une charge complémentaire de la batterie, effectuée par exemple à l'étape 160 du procédé 100.

Dans un exemple de ce second mode d'implémentation, le modèle peut comprendre l'équation polynomiale d'ordre 2 suivante :

$$SOH(DCR) = n_1 \cdot DCR^2 + n_2 \cdot DCR + n_3$$

Avec :

-    *DCR,* la résistance en courant continu DCR obtenue à l'étape 130

$n_1$, $n_2$, $n_3$ les coefficients à déterminer.

Ces coefficients $n_1$, $n_2$, $n_3$ peuvent être déterminés lorsque le modèle de la batterie est généré, par exemple à l'aide de l'exemple décrit précédemment, à l'aide d'un algorithme d'optimisation tel que la méthode des moindres carrés afin d'ajuster l'équation aux données expérimentales obtenues.

Dans ce second mode d'implémentation, la résistance en courant continu DCR peut être calculée de la manière suivante :

$$DCR_{\Delta t} = \frac{U(t) - U(t - \Delta t)}{I(t)}$$

Avec :

-    *t*, l'instant présent,

-    *I(t),* le courant constant appliqué à la batterie

-    *∆t,* l'intervalle de temps entre l'instant présent *t* et le début de l'application du courant *I(t)*.

Il est possible de noter que généralement, la résistance en courant continu DCR est calculée pour des périodes de temps courtes, allant de 1 à 60 secondes. Dans l'équation présentée précédemment, la variation de la tension en circuit ouvert OCV est négligée, ce qui est raisonnable pour des faibles variations de l'état de charge SOC de la batterie, et donc pour un intervalle de temps *∆t* court, i.e. inférieur ou égal à 60 secondes par exemple.

Lorsque l'état de charge SOC de la batterie varie de façon importante, l'équation suivante est préférable :

$$DCR_{\Delta t} = \left| \frac{[U(t) - OCV(t)] - [U(t - \Delta t) - OCV(t - \Delta t)]}{I(t)} \right|$$

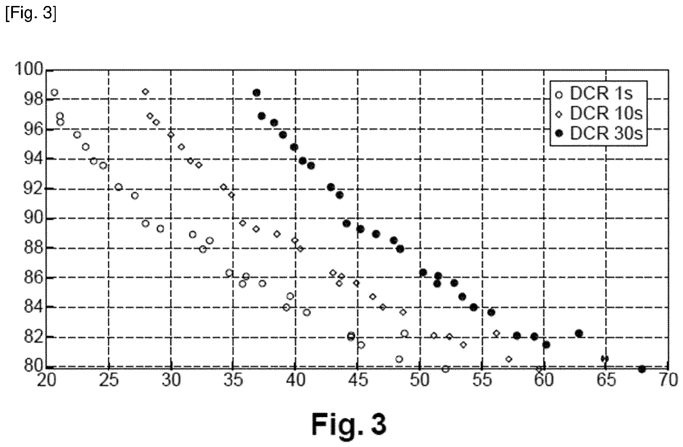

Ainsi, lorsque l'état de charge SOC de la batterie varie de façon importante, l'état de charge SOC de la batterie peut être préalablement obtenu, par exemple en utilisant un estimateur de l'état de charge SOC de la batterie. L'état de charge SOC de la batterie peut ensuite être utilisé pour déterminer la tension en circuit ouvert OCV à partir d'une cartographie préétablie de la tension en circuit ouvert OCV en fonction de l'état de charge SOC de la batterie, de la température et du SOH. Il est possible de noter que d'autres méthodes pour déterminer la tension en circuit ouvert OCV pourraient être envisagées. La figure 3 est un graphique ayant pour axe vertical l'état de santé SOH de la batterie, exprimé en pourcentages de la capacité $C_{initiale}$ maximale initiale de la batterie, et pour axe horizontal la résistance en courant continu DCR, exprimée en milliOhms (mΩ). Le graphique de la figure 3 montre un exemple de relation obtenue entre l'état de santé SOH de la batterie et la résistance en courant continu DCR calculée pour trois intervalles de temps de 1 seconde, 10 secondes et 30 secondes.

Une cinquième étape 150 du procédé 100 comprend la détermination de l'état de santé SOH de la batterie en fournissant au modèle obtenu à l'étape 140 l'indicateur obtenu à l'étape 130. Par exemple, si le modèle comprend une fonction définissant l'état de santé SOH de la batterie en fonction de l'indicateur de la batterie, l'état de santé SOH de la batterie est obtenu en évaluant la fonction *f* avec la valeur obtenue à l'étape 130 de l'indicateur de la batterie.

Une sixième étape 160 optionnelle du procédé 100 comprend une charge complémentaire de la batterie jusqu'à atteindre une seconde tension $U_{max}$ prédéterminée et/ou un état de charge prédéterminé. La seconde tension $U_{max}$ prédéterminée est alors supérieure à la première tension $U_{max}$ prédéterminée. En alternative ou en combinaison, la charge complémentaire 160 est mise en œuvre pendant une durée prédéterminée, comprise par exemple entre 1 et 60 secondes.

Dans un exemple, compatible avec les exemples précédents, la seconde tension $U_{max}$ prédéterminée est inférieure à la tension maximale admissible qui peut être fournie par le fabriquant de la batterie.

Dans un exemple, compatible avec les exemples précédents, le procédé 100 est utilisé dans un protocole de charge de la batterie. Ce protocole de charge peut être utile d'un point de vue logistique. Par exemple, lorsque la batterie est utilisée pour assurer la propulsion d'un aéronef du type eVTOL, pour « electrical Verfical Take-Off and Landing » en anglais, il est possible que l'aéronef effectue plusieurs missions dans une journée, intercalées avec des charges partielles relativement rapides, et qu'il reste quelques heures en repos pendant la nuit. Afin d'éviter le vieillissement prématuré de la batterie, l'idéal est de stocker la batterie à un état de charge SOC d'environ 30%, voire 50%. Un état de charge SOC trop faible ou trop élevé peut accélérer la dégradation de la batterie. Ainsi, avec ce protocole de charge, la batterie conserve durant une majorité de son temps de repos un état de charge SOC moyen et n'est chargée complètement que quelques minutes voire heures avant sa première mission de la journée.

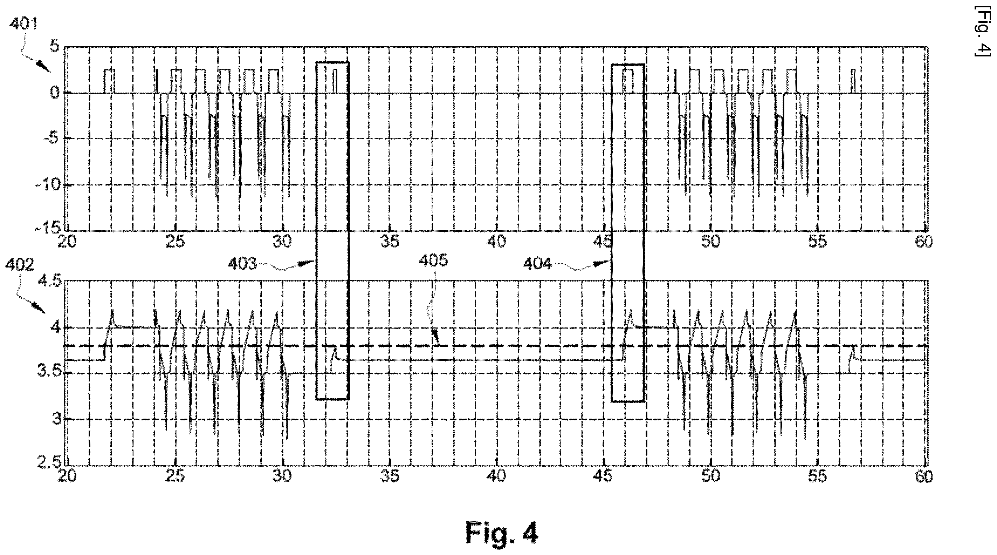

La figure 4 est un graphique illustrant un exemple de profil du courant et de la tension de la batterie lors de ce protocole de charge. Sur cette figure 4, les axes horizontaux représentent le temps, en heures, et l'axe vertical du graphique 401 représente l'intensité du courant, exprimée en ampères, appliqué à la batterie alors que l'axe vertical du graphique 402 représente la tension, exprimée en volts, de la batterie. Sur cette figure 4, l'aéronef effectue une six missions entre la 24$^{ème}$ et la 30$^{ème}$ heure et six autres missions entre la 48$^{ème}$ et 54$^{ème}$ heure. L'étape 110 de charge initiale, matérialisée par le rectangle 403 sur la figure 4, est effectuée à la 32$^{ème}$ heure jusqu'à obtenir la première tension $U_{stop}$ prédéterminée, notée 405 sur la figure 4. L'étape 160 de charge complémentaire est effectuée à la 46$^{ème}$ heure, matérialisée par le rectangle 404 sur la figure 4.

La septième étape 170 optionnelle comprend la modification des conditions d'utilisation de la batterie en fonction de l'état de santé SOH déterminé à l'étape 150. Par exemple, lorsque l'état de santé SOH déterminé 150 est inférieur à une valeur d'état de santé SOH prédéterminée par exemple 70 ou 80%, la modification des conditions d'utilisation de la batterie peut consister à remplacer la batterie par une nouvelle batterie. La batterie dont l'état de santé SOH déterminé est inférieur à une valeur d'état de santé SOH prédéterminé peut par exemple être utilisée dans des applications dites de seconde vie. Dans un deuxième exemple, la modification des conditions d'utilisation de la batterie peut consister à charger la batterie, par exemple lors de l'étape 160, à une intensité de courant inférieure ou égale à une intensité de courant maximale, l'intensité de courant maximale étant déterminée à partir de l'état de santé SOH déterminé.

Il est aussi possible de noter que le procédé de détermination de l'état de santé SOH d'une cellule électrique peut être utilisé en tant qu'entrée pour des procédés de détermination d'autres paramètres de la cellule électrique comme par exemple l'état de charge SOC de la cellule électrique, l'état d'énergie SOE de la cellule électrique ou encore l'état de puissance SOP de la cellule électrique.

Sauf précision contraire, un même élément apparaissant sur des figures différentes présente une référence unique.

**Revendications**

1. Procédé (100) de surveillance d'un état de santé SOH d'une batterie, comprenant des étapes de :

   - charge (110) initiale de la batterie jusqu'à atteindre une première tension $U_{stop}$ prédéterminée comprise entre 3,5 et 4,1 volts, la charge initiale de la batterie étant effectuée en appliquant un courant constant,
   - mise au repos (120) de la batterie pendant une durée adaptée pour qu'à une fin de la mise au repos :

     o une tension de la batterie soit égale, ou suffisamment proche, à une tension en circuit ouvert OCV de la batterie, et
     o une température de la batterie soit stable,

   - obtention (130) d'un indicateur de la batterie parmi :

     ○ la tension en circuit ouvert OCV de la batterie,
     ○ une résistance en courant continu DCR de la batterie,

   - obtention (140) d'un modèle de la batterie prenant en entrée l'indicateur de la batterie et fournissant en sortie l'état de santé SOH de la batterie, et
   - détermination (150) de l'état de santé SOH de la batterie en fournissant au modèle obtenu (140) l'indicateur obtenu (130).

2. Procédé (100) selon la revendication 1, comprenant en outre une charge (160) complémentaire de la batterie :

- pendant une durée prédéterminée, et/ou
- jusqu'à atteindre une seconde tension $U_{max}$ prédéterminée, et/ou
- un état de charge prédéterminé.

3. Procédé (100) selon la revendication 1 ou 2 comprenant en outre une modification (170) des conditions d'utilisation de la batterie en fonction de l'état de santé SOH déterminé (150), la modification (170) des conditions d'utilisation de la batterie comprenant :

- lorsque l'état de santé SOH déterminé (150) est inférieur à une valeur seuil d'état de santé prédéterminé, remplacer la batterie par une nouvelle batterie, et/ou
- charger la batterie, lors de la charge (160) complémentaire à une intensité de courant inférieure ou égale à une intensité de courant maximale, l'intensité de courant maximale étant déterminée à partir de l'état de santé SOH déterminé (150).

4. Procédé (100) selon l'une quelconque des revendications précédentes dans lequel la durée de la mise au repos (120) de la batterie est égale ou supérieure à une heure.

5. Procédé (100) selon l'une quelconque des revendications précédentes dans lequel l'indicateur de la batterie est la tension en circuit ouvert OCV de la batterie.

6. Procédé (100) selon l'une quelconque des revendications 2 à 4 dans lequel :

- l'indicateur de la batterie est la résistance en courant continu DCR de la batterie, et
- l'obtention (130) de la résistance en courant continu DCR de la batterie est effectuée au début de la charge (160) additionnelle de la batterie.

7. Système de gestion d'une cellule électrique comprenant des moyens de mise en œuvre du procédé selon l'une des revendications précédentes.

8. Aéronef comprenant une batterie et un système de gestion de la batterie selon la revendication précédente.

9. Programme d'ordinateur comprenant des instructions qui, lorsque le programme est exécuté par un ordinateur, conduisent celui-ci à mettre en œuvre un procédé selon l'une quelconque des revendications 1 à 6.

10. Support de données lisible par ordinateur, sur lequel est enregistré le programme d'ordinateur selon la revendication 9.

[Fig. 1]

**Fig. 1**

[Fig. 2]

**Fig. 2**

[Fig. 3]

Fig. 3

[Fig. 4]

Fig. 4

**Europäisches Patentamt**
**European Patent Office**
**Office européen des brevets**

# RAPPORT DE RECHERCHE EUROPEENNE

Numéro de la demande

EP 25 17 4252

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2013/138369 A1 (PAPANA ANKI REDDY [IN] ET AL) 30 mai 2013 (2013-05-30) | 1-3,5-10 | INV.<br>G01R31/367 |
| Y | * equations (1)-(11); alinéas [0002], [0009], [0010], [0024] - alinéa [0046]; revendications 1-17; figures 1-9 * | 4 | G01R31/392<br>H02J7/00<br><br>ADD.<br>H01M10/48 |
| Y | US 2020/292622 A1 (WU BILLY [GB] ET AL) 17 septembre 2020 (2020-09-17) * alinéa [0045] - alinéa [0068]; revendications 1-26; figures 1-10 * | 4 | |

-----

-----

**DOMAINES TECHNIQUES RECHERCHES (IPC)**

G01R
H01M
H02J

Le présent rapport a été établi pour toutes les revendications

| Lieu de la recherche | Date d'achèvement de la recherche | Examinateur |
|---|---|---|
| La Haye | 26 août 2025 | Oliveira Braga K., A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 17 4252

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-08-2025

| Document brevet cité au rapport de recherche | Date de publication | Membre(s) de la famille de brevet(s) | | Date de publication |
|---|---|---|---|---|
| US 2013138369 A1 | 30-05-2013 | CN | 103149535 A | 12-06-2013 |
| | | EP | 2597479 A2 | 29-05-2013 |
| | | JP | 2013122450 A | 20-06-2013 |
| | | US | 2013138369 A1 | 30-05-2013 |
| US 2020292622 A1 | 17-09-2020 | CN | 109154636 A | 04-01-2019 |
| | | EP | 3433628 A1 | 30-01-2019 |
| | | US | 2020292622 A1 | 17-09-2020 |
| | | WO | 2017163089 A1 | 28-09-2017 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **SHEN, P.** ; **OUYANG, M.** ; **LU, L.** ; **LI, J.** ; **FENG, X.** The co-estimation of State of Charge, State of Health, and State of Function for lithium-ion batteries in electric vehicles. *IEEE Transactions on Vehicular Technology*, 2018, vol. 67 (1), 92-103

- Online State of Health Estimation Method for Lithium-ion Batteries Based on Integrated Voltage. **ZHOU, Y.** ; **HUANG, M.** ; **PECHT, M.** 2018 IEEE International Conference on Prognostics and Health Management, ICPHM. 27 August 2018